Europäisches Patentamt

(19) European Patent Office

Office européen des brevets

(11) Publication number: **0 218 193 B1**

# EUROPEAN PATENT SPECIFICATION

(45) Date of publication of patent specification: **13.05.92** (51) Int. Cl.⁵: **H01L 27/14**, H01L 31/18

(21) Application number: **86113552.3**

(22) Date of filing: **02.10.86**

(54) **Process and apparatus for continuous production of lightweight arrays of photovoltaic cells.**

(30) Priority: **11.10.85 US 786782**

(43) Date of publication of application:
**15.04.87 Bulletin 87/16**

(45) Publication of the grant of the patent:
**13.05.92 Bulletin 92/20**

(84) Designated Contracting States:
**AT BE CH DE ES FR GB GR IT LI LU NL SE**

(56) References cited:
**EP-A- 0 041 773     EP-A- 0 192 280**
**BE-A- 622 403       DE-A- 2 856 510**
**US-A- 4 341 588     US-A- 4 419 178**

(73) Proprietor: **ENERGY CONVERSION DEVICES, INC.**
**1675 West Maple Road**
**Troy Michigan 48084(US)**

(72) Inventor: **Hanak, Joseph J.**
**1028 Ridgedale**
**Birmingham, MI 48008(US)**

(74) Representative: **Müller, Hans-Jürgen, Dipl.-Ing. et al**
**Müller, Schupfner & Gauger Maximilian-strasse 6 Postfach 10 11 61**
**W-8000 München 1(DE)**

## Description

Technology for manufacturing large-area photovoltaic cells from amorphous semiconductor alloys has been developed in recent years. Breakthroughs have been made in preparing amorphous semiconductor materials of electronic device quality. These high quality materials include hydrogen, fluorine, or a combination of the two in a host matrix of amorphous silicon, silicon-germanium, and germanium. It is believed that hydrogen and fluorine passivate or satisfy dangling bonds and other structural defects in the amorphous structure so that desirable charge carrier transport properties are achieved.

The principal method of preparing these amorphous semiconductor materials is glow discharge deposition. In that process, a gas mixture containing at least one semiconductor precursor gas, such as silane, disilane, silicon tetrafluoride, germane, and germanium tetrafluoride or mixtures thereof, is admitted to a vacuum chamber held at a reduced pressure, typically 13 to 65 pascal. The gas mixture may also include hydrogen or argon as a diluent and a dopant precursor gas, such as diborane or boron trifluoride to deposit a p-type conductivity material or phosphine or phosphorus tetrafluoride to deposit an n-type conductivity material. The gas mixture also includes a precursor source of hydrogen and/or fluorine. Material deposited without the presence of a dopant precursor gas is typically slightly n-type in conductivity, is substantially intrinsic and may be compensated to a higher resistivity with a trace of a p-type dopant, such as boron.

The gas mixture is admitted to the chamber through a gas inlet or through the cathode itself. A glow discharge plasma is struck between the cathode and an electrically conductive substrate by impressing an electrical potential across the cathode and substrate disposed adjacent thereto. The glow discharge plasma is sustained by electrical power that may be direct current or may be alternating current up through the microwave frequency range. The glow discharge disassociates the gas mixture into various species that deposit on the substrate and build up the depositing semiconductor alloy material. By changing dopant precursor gases during the deposition process, p-n, p-i-n and more complex device structures may be deposited. Three layer p-i-n and multiple p-i-n amorphous silicon alloy and amorphous silicon-germanium alloy structures have proven particularly useful as photovoltaic and photosensitive devices.

The process of producing glow discharge deposited amorphous photovoltaic devices has been developed to permit the continuous deposition of such materials over large areas. For example, methods for the continuous production of amorphous photovoltaic material on large-area, flexible metallic substrates has been disclosed in U.S. Patents: 4,400,409 to Izu, et al for Method of Making P-Doped Silicon Films; 4,410,558 and 4,519,339 to Izu, et al for Continuous Amorphous Solar Cell Production System; 4,485,125 to Izu, et al for Method for Continuously Producing Tandem Amorphous Photovoltaic Cells; 4,492,181 to H. Ovshinsky, et al for Method for Continuously Producing Tandem Amorphous Photovoltaic Cells; and 4,514,437 to Nath for Apparatus for Plasma Assisted Evaporation of Thin Films and Corresponding Methods of Deposition. The disclosures of these patents are incorporated herein by reference. Apparatus for depositing complex amorphous semiconductor alloy devices on flexible substrate 30 cm. wide and over 300 m. long has been built and is now operating.

More recently very lightweight amorphous semiconductor alloy arrays of photovoltaic cells have been constructed from continuously deposited alloy materials. These lightweight cells have an exceptionally high specific power, i.e. power output to mass ratio. The lightweight cells are prepared in the way described above, but on a very thin substrate, such as electroformed metal foil, or a metal substrate that is chemically etched to an unconventional thinness, or on an insulator initially supported by a metal substrate that is completely removed by chemical etching after deposition of the amorphous alloy. See U.S. patent application serial no. 696,390 filed January 30, 1985, by Hanak for Extremely Lightweight, Flexible Semiconductor Device Arrays and Method of Making Same. It is desirable to fabricate these extremely lightweight arrays directly from continuous processing machinery rather than to thin or remove a conventional thickness substrate in order to reduce the number of process steps and thereby to improve yield and to reduce cost. It is also desirable to avoid the use of a very thin electroformed foil because of the special care required in handling that delicate foil.

## SUMMARY OF THE INVENTION

It is an object of the present invention to provide a method for producing a large-area lightweight array of thin film photovoltaic cells.

This object is attained by a continuous process, which is characterized by continuously depositing on a surrogate substrate a thin amorphous semiconductor alloy film of about one micrometer or less and providing electrical contacts, the electrical contact on the light incident side of the cell being transparent; patterning said semiconductor alloy film on said surrogate substrate; continuously applying a support material atop said deposited semiconductor alloy film; and continuously separating said semiconductor alloy film and support material from said surrogate substrate due to the adherence of the film and the substrate being less than the adherence between the film and the support material.

In a preferred embodiment of the invention, the surrogate substrate is an endless band that cycles through a deposition apparatus. The semiconductor alloy film is deposited, preferably by glow discharge, to form a preselected photovoltaic structure, the support material is laminated thereupon and the film is peeled from the surrogate substrate. The bare substrate is then recycled back through the deposition apparatus for having a subsequent semiconductor alloy film deposited thereupon. The deposition, lamination, peeling and cleaning processes all preferably proceed continuously.

The surrogate substrate may be chosen to have a thermal coefficient of expansion different from that of the semiconductor alloy film to aid in separation. A thermal shock may be applied by exposing one side of the substrate to heat or cold. For the deposition of a silicon alloy photovoltaic film, it is preferred to form the surrogate substrate from stainless steel.

Other processing steps may be used to form electrical contacts on the lightweigth array photovoltaic material, to laminate additional protective layers onto the semiconductor alloy film and to eliminate any electrical defects that may result from separating the semiconductor alloy film from the substrate.

BRIEF DESCRIPTION OF THE DRAWINGS

Figure 1 is a schematic, cross sectional view of one embodiment of a continuous deposition, substrate removal and laminating apparatus adapted to carry out the principles of the inventive process;

Figure 2 is a schematic, cross sectional view of an apparatus for applying a thermal shock according to a first embodiment of the subject invention; and

Figure 3 is a schematic, cross-sectional view of another embodiment of the thermal shock apparatus of Figure 2.

DETAILED DESCRIPTION OF PREFERRED EMBODIMENTS

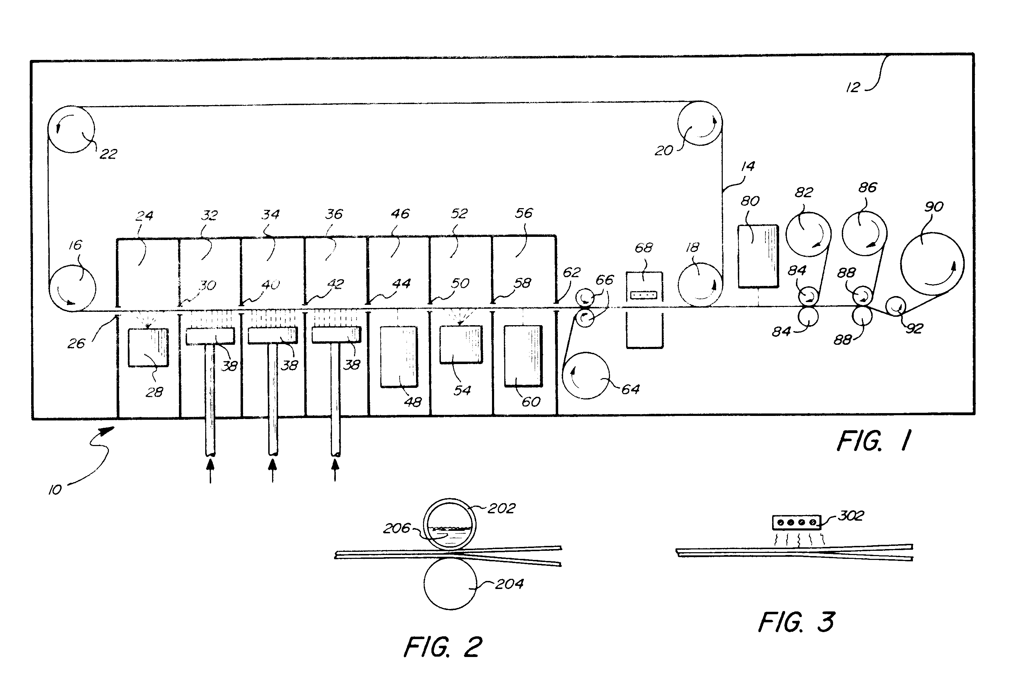

An embodiment of a novel apparatus 10 for carrying out the inventive process is shown in a schematic, cross sectional view in Figure 1. In general, apparatus 10 includes a large vacuum envelope 12 in which a subatmospheric pressure may be established and maintained by vacuum pumps (not shown). Within envelope 12 there are various chambers, some communicating with others, in which the ambient gases and pressures may be independently controlled.

Within envelope 12 an endless surrogate substrate 14, preferably formed of stainless steel or some other material that has a thermal coefficient of expansion substantially different from that of the amorphous semiconductor alloy being deposited, is trained around four rollers 16, 18, 20 and 22. These rollers are driven by a motor (not shown) to move the endless substrate through the envelope 12. Additional tensioning and steering rollers may be used to keep surrogate substrate 14 taut and to maintain transverse alignment during travel.

Since the substrate 14 may be treated in various ways within envelope 12, the following description is merely illustrative of one possible sequence of treatments. It is to be understood that some of the described treatments can be omitted, others added and some of those shown can be performed multiple times.

As moving substrate 14 travels away from roller 16 toward roller 18, it enters a deposition chamber 24 through a gas gate 26. Gas gate 26 is supplied with an inert gas that sweeps across and through the opening of chamber 24 to isolate its environment from that of envelope 12. Examples of such gas gates are described in U.S. Patents: 4,438,724 to Doehler, et al for Grooved Gas Gate; 4,450,786 to Doehler, et al for Grooved Gas Gate; 4,462,332 to Nath, et al for Magnetic Gas Gate; 4,480,585 to Gattuso for External Isolation Module; and 4,537,795 to Nath, et al for Method for Introducing Sweep Gases Into a Glow Discharge Deposition Apparatus. The disclosure of these patents are incorporated herein by reference.

Within chamber 24 a metallic or conductive film is deposited on substrate 14 to form an electrode, called a back electrode because of its location at the rear of the photovoltaic cells to be formed, for electrical interconnection of the photovoltaic cells to be produced. The back electrode may also be reflective to reflect light back into the cell for the absorption of the light that reaches the bottom of the cell. The back electrode may be deposited by sputtering, as illustrated by a sputtering source 28 disposed within chamber 24. Other processes, such as radio frequency sputtering or a vapor deposition, can be used to deposit the back electrode.

After the deposition of the electrically conducting back electrode, substrate 14 moves out of chamber 24, through another gas gate 30 and into an adjacent chamber 32. While chambers 24 and 32 are shown as adjacent, they may be separated within the envelope 12 and an exit gas gate may be fitted to chamber 24 and an entrance gas gate fitted to chamber 32. For simplicity, however, the chambers are shown in adjacent relationship in Figure 1 with a single gas gate disposed therebetween. Likewise, other chambers within envelope 12 are shown as disposed adjacent one another, but it is understood they may be separated and two gas gates may be required where only one is shown in Figure 1.

Chamber 32 is the first of three related semiconductor deposition chambers 32, 34 and 36. In each of these chambers, a layer of semiconductor alloy film is deposited by establishing and maintaining glow discharge conditions in a gas mixture containing at least one semiconductor precursor gas. For the sake of simplicity, a combination cathode and gas dispenser 38 is shown disposed in each of chambers 32, 34 and 36. Examples of such cathodes are described in U.S. Patents: 4,369,730 to Izu, et al for Cathode for Generating a Plasma; and 4,483,883 to Nath, et al for Upstream Cathode Assembly, the disclosures of which are incorporated herein by reference. It should be apparent that other gas introductory systems which are well known to those skilled in the art could be also employed, such as the introduction manifold disclosed and illustrated in U.S. Patent No. 4,513,684 to Nath, et al, the disclosure of which is also incorporated by reference. Each cathode is driven by an electrical energy source (not shown) adapted to supply direct current or alternating current at a preselected frequency from radio through the microwave range. Substrate 14 is electrically connected to the electrical energy source so that a glow discharge may be established and maintained in each of the deposition chambers 32, 34 and 36 in the space formed between the substrate 14 and the respective cathodes 38.

Chambers 32, 34 and 36 are interconnected by gas gates 40 and 42, respectively, so that the respective gaseous environments thereof are isolated from each other. Those gas mixtures are supplied to cathodes 38 as stylistically indicated by the arrows. As is known in the art, the gas mixtures contain not only at least one semiconductor precursor gas, such as silane, disilane, silicon tetrafluoride, germane, germanium tetrafluoride and mixtures of these gases, but also a source of hydrogen and/or fluorine to passivate defects in the deposited amorphous semiconductor alloy. In addition, a diluent gas such as argon or hydrogen may be supplied. The apparatus shown is specifically adapted to deposit a p-i-n or n-i-p structure. That is, a dopant precursor gas, such as diborane or boron trifluoride is added to the gas mixture in chamber 32 or 36 to deposit a p-type conductivity layer. Another dopant precursor gas, such as phosphine or phosphorus pentachloride, is added to the gas mixture in the other of chambers 32 or 36 to deposit an n-type layer. Neither dopant precursor gas or only trace amounts of a p-type dopant precursor gas are added to the gas mixture in chamber 34 to deposit a substantially intrinsic type layer of semiconductor alloy material in that chamber. Thus a p-i-n or n-i-p structure is formed. If a simpler structure is desired, one or more chambers can be removed. If a more complex structure, such as a tandem or two cell structure, is desired, additional deposition chambers can be added to apparatus 10.

Upon completion of the deposition of the at least one triad of three layer amorphous semiconductor alloy film on substrate 14 (or on the back electrode), substrate 14 exits from chamber 36 through a gas gate 44 and enters chamber 46. If desired, the deposited semiconductor alloy film can be formed into a pattern of small area cells in chamber 46. A laser scriber 48 is disposed in chamber 46, which scriber 48 is specifically adapted to form a desired pattern of such small area cells in the large area semiconductor alloy film by scanning its relatively high powered beam across the film in a preselected pattern, thereby removing the film from those portions which the beam strikes. Such scribers are disclosed in U.S. Patent 4,292,092 to Hanak, the disclosure of which is incorporated herein by reference.

After the scribing treatment in chamber 46, if any, the semiconductor alloy film on the substrate 14 moves through a gas gate 50 and into another deposition chamber 52 disposed adjacent thereto. In chamber 52 a transparent, electrically conductive layer, such as indium tin oxide, tin oxide, zinc oxide, cadmium stannate or cadmium tin oxide, is deposited on the semiconductor alloy film. This conductive layer forms the front electrode, so-named because of its position on the light-incident side of the array of lightweight photovoltaic cells being fabricated. The technique for the deposition of the transparent, electrically conductive layer may be chosen from numerous known processes such as d.c. sputtering, a.c. sputtering, magnetron sputtering and evaporation. A sputtering source 54 is shown disposed in chamber 52 for implementing a sputtering embodiment of that deposition process.

In a final, optional processing step, the semiconductor alloy film with the transparent conductive layer deposited thereupon moves out of the sputtering chamber 52 into an adjacent patterning chamber 56 through a gas gate 58. In chamber 56, the transparent conductive layer is formed into patterns of interconnections by a scanning laser scriber 60 disposed therein. Laser 60 operates in a manner generally similar to the operation of laser scriber 48 described hereinabove, so as to selectively remove the transparent conductive material to leave a preselected pattern of conductive material interconnecting the small area photovoltaic cells.

After patterning the transparent conductive layer, the cell fabrication steps have been completed and the processed semiconductor alloy material is ready to be peeled away or otherwise remove from substrate 14. However, it must be noted that the total thickness of the semiconductor alloy film, the back reflector and the front electrode layer is no more than 1.0 micrometer and is frequently thinner. Consequently, these thin films are too delicate for direct handling, so a support material is bonded or otherwise affixed to the front electrode to add mechanical strength to the cell structure prior to removing the surrogate substrate. The substrate and deposited layers exit from chamber 56 through a final gas gate 62 to a laminating station at which a laminate, which must be transparent if the semiconductor alloy film is to be used for photovoltaic applications, is applied to the front electrode thereof. Ethyl vinyl acetate may be used as one such laminating material. The laminating material is fed from a supply coil 64 to a pair of rollers 66 through which the substrate 14 and deposited semiconductor alloy film simultaneously pass. Rollers 66 are preferably heated to the extent necessary to bond the support material to the semiconductor alloy film, while applying the minimum possible pressure in order to avoid damaging to the film. Alternatively, the support material may be coated with a pressure sensitive adhesive for bonding to the semiconductor alloy film. Since the film, as now laminated, has sufficient strength to withstand further handling, it is ready to be separated from substrate 14.

The substrate, semiconductor alloy film and laminated support material next pass to a separating station 68. If the semiconductor alloy film does not adhere well to the surrogate substrate 14, the mere flexing of that substrate 14 as it passes about roller 18 will be sufficient to cause separation of the substrate from the film and laminated support material. Alternatively, the film, substrate and laminated material may be exposed to a differential thermal shock. Because the thermal coefficient of expansion of the substrate and the semiconductor alloy film relative to the coefficient of expansion of the semiconductor alloy film and support material are different, the thermal shock causes the substrate to separate from the film and laminate. Substrate 14 then continues to rotate around rollers 18 and 22 to be reused in the continuous processing of the semiconductor alloy film. The semiconductor alloy film and laminated support material continues downstream for further processing as explained below.

Various means may be used to apply a thermal shock to the substrate-semiconductor alloy film combination at station 68, a first preferred embodiment thereof being shown in Figure 3. There, a bank of radiant heaters 302 is disposed proximate substrate 14 so as to heat the substrate 14. Since the substrate expands more rapidly than the semiconductor alloy film, the heat from heater 302 achieves the desired separation. Heaters 302 do not require seals to isolate them from the rest of the processing equipment and avoid potentially damaging mechanical contact with the semiconductor alloy film.

A second preferred embodiment of a thermal shock treatment is shown in Figure 2. There, a pair of oppositely disposed rollers, 202 and 204, contact the substrate 14 and exposed surface of the semiconductor alloy film, respectively. Roller 202 contacts surrogate substrate 14 and contains a relatively cold or hot liquid 206. The heat transfer between roller 202 and substrate 14 provides a thermal shock that separates the substrate from the semiconductor alloy film. Roller 202 may extend beyond envelope 12 or the interior of roller 202 may be accessible from outside envelope 12 to permit the continuous circulation of a liquid into roller 202 to maintain a desired temperature.

After the semiconductor alloy film and laminated support material 64 are separated from substrate 14, further processing may occur. When the semiconductor alloy film is stripped from substrate 14, the back electrode, if one was deposited, becomes accessible and may be formed into a pattern of electrical interconnections with a laser scriber in the same manner as the semiconductor alloy film and transparent conductive layer were previously patterned. To that end, a laser 80 is disposed in envelope 12 adjacent the exposed back electrode to scan a preselected pattern, removing portions of the conductive back electrode, thereby forming the desired electrical interconnections. While laser 80 is shown within the envelope 12, it may be operatively disposed within a discrete chamber to contain and collect the debris produced in the laser scribing process.

After the back electrode is patterned, additional metallization may be applied to complete electrical contacts to the "substrate" side of the web of photovoltaic material. These contacts may be predeposited on a roll of a material that is applied to the semiconductor alloy film in registration with the pattern produced by laser 80, or the contacts may be predeposited on a continuous, skeletal web wound on a roll that is applied to the semiconductor alloy film in registration with the patterned back electrode thereof. A coil 82 of such a film or skeletal web is disposed adjacent the moving web of laminated semiconductor alloy film and is bonded to the patterned back electrode thereof between a pair of rollers 84 disposed on opposite sides thereof. The bonding may be thermally assisted.

Finally, a rear laminate may be applied to the backside of the web of photovoltaic material for added strength and protection, without the substantial addition of weight. To that end, a supply roll 86 of a lightweight polymeric film such as ethylene, vinyl acetate, a fluoropolymer, an acrylic or a polyimide is applied to the web of laminated semiconductor alloy film between two rollers 86 disposed on opposite sides thereof. The polymeric film may be thermally bonded to the web or a pressure sensitive adhesive may be used.

The completed lightweight, large-area array of photovoltaic cells is then collected and stored on a take-up coil 90. A steering and tensioning roller 92 disposed between rollers 88 and take-up coil 90 maintains the proper tension on the web of laminated photovoltaic material and maintains it in the appropriate transverse attitude.

While Figure 1 has been described with respect to a particular sequence of processing, the processing steps may be performed in a different sequence or some steps may be deleted and others added. For example, it may be desirable to deposit the semiconductor alloy film directly on the surrogate substrate 14 by omitting the deposition of the back electrode until other processing is complete. In that case, all processing which occurs after the separation of the surrogate substrate 14 from the semiconductor alloy film would be omitted from apparatus 10 and would be performed in different apparatus. Further, it might be desirable that the semiconductor alloy film and transparent conductive layer deposited on the front side of the web of photovoltaic material might not be patterned in apparatus 10 to avoid creating debris. Again, in that processing sequence, no further processing steps would be performed in apparatus 10 subsequent to the separation of the semiconductor alloy film from the surrogate substrate. Rather, the semiconductor alloy film could be patterned by water jet, laser scribing or by chemical or electrochemical etching from the back side thereof. After this processing step, electrical contacts would be applied to the back side of the semiconductor alloy film and finally a laminate would be applied to the back side thereof to protect and strengthen the overall structure.

While the apparatus of Figure 1 shows surrogate substrate 14 as an endless band, continuous processing could also be achieved in a similar manner with an elongated surrogate substrate. To that end, roller 22 would be replaced by a supply coil of substrate material and roller 20 would be replaced by a take-up reel for collecting the surrogate substrate after the semiconductor alloy film has been deposited and separated therefrom.

## Claims

1. A continuous process for producing large-area. lightweight array of thin film photovoltaic cells (90) characterized by:
   continuously depositing on a surrogate substrate a thin amorphous semiconductor alloy film of about one micrometer or less and providing electrical contacts, the electrical contact (82) on the light incident side of the cell being transparent;
   patterning (50) said semiconductor alloy film on said surrogate substrate;
   continuously applying a support material atop said deposited semiconductor alloy film; and
   continuously separating said semiconductor alloy film and support material from said surrogate substrate due to the adherence of the film and the substrate being less than the adherence between the film and the support material.

2. The process of Claim 1 including thermally bonding said support material to said semiconductor alloy film.

3. The process of Claim 1 wherein said surrogate substrate is an endless band (14).

4. The process of Claim 1 including continuously depositing said semiconductor alloy film by establishing and maintaining a glow discharge.

5. The process of Claim 1 wherein the separation includes subjecting said film, surrogate substrate and support material to a thermal shock (302);
   said surrogate substrate having a coefficient of thermal expansion different than that of the film.

6. The process of Claim 1 wherein said surrogate substrate comprises stainless steel.

7. The process of Claim 5 wherein heating is employed to create said thermal shock.

8. The process of Claim 1 including forming (80) said semiconductor alloy film into individual photovoltaic cells after separating said film and support material from said surrogate substrate.

**9.** The process of Claim 1 including depositing an electrically conducting layer on said surrogate substrate before depositing said film.

**Revendications**

**1.** Procédé de production en continu d'un réseau léger de grande surface de cellules photovoltaïques à film mince (90) caractérisé par

le dépôt en continu sur un substrat spécial d'un film mince d'alliage semi-conducteur amorphe d'environ un micromètre d'épaisseur ou moins et formation de contacts électriques, le contact électrique (82) sur la face de la cellule où arrive la lumière étant transparent :

la formation d'une configuration (50) dudit film d'alliage semi-conducteur sur ledit substrat spécial ;

l'application en continu d'un matériau support par dessus ledit film d'alliage semi-conducteur déposé ; et

la séparation en continu dudit film d'alliage semi-conducteur et du matériau support par rapport audit substrat préparé du fait que l'adhérence entre le film et le substrat est inférieure à l'adhérence entre le film et le matériau support.

**2.** Procédé selon la revendication 1, comprenant une fixation thermique dudit matériau support sur ledit film d'alliage semi-conducteur.

**3.** Procédé selon la revendication 1, dans lequel le substrat préparé est une bande sans fin (14).

**4.** Procédé selon la revendication 1, comprenant le dépôt en continu dudit film d'alliage semi-conducteur en établissant et en entretenant une décharge lumineuse.

**5.** Procédé selon la revendication 1, dans lequel l'opération de séparation consiste à soumettre ledit film, le substrat préparé et le matériau support à un choc thermique (302) ;

ledit substrat préparé ayant un coefficient de dilatation thermique différent de celui du film.

**6.** Procédé selon la revendication 1, dans lequel ledit substrat préparé est en acier inoxydable.

**7.** Procédé selon la revendication 5, dans lequel un chauffage est employé pour créer ledit choc thermique.

**8.** Procédé selon la revendication 1, comprenant la formation (80) dudit film d'alliage semi-conducteur en cellules photovoltaïques individuelles après la séparation dudit film et du matériau support par rapport audit substrat préparé.

**9.** Procédé selon la revendication 1 comprenant le dépôt d'une couche électriquement conductrice sur ledit substrat préparé avant le dépôt dudit film.

**Patentansprüche**

**1.** Kontinuierliches Verfahren zur Herstellung einer großflächigen leichten Anordnung von photovoltaischen Dünnschichtzellen (90),
**gekennzeichnet durch**

kontinuierliches Abscheiden einer amorphen Halbleiterlegierungs-Dünnschicht von ca. 1 $\mu$m oder Weniger auf einem Ersatzsubstrat, wobei der elektrische Kontakt (82) auf der Lichteinfallseite der Zelle lichtdurchlässig ist;

Strukturieren (50) der Halbleiterlegierungsschicht auf dem Ersatzsubstrat;

kontinuierliches Aufbringen eines Trägermaterials auf der abgeschiedenen Halbleiterlegierungsschicht; und

kontinuierliches Trennen der Halbleiterlegierungsschicht und des Trägermaterials von dem Ersatzsubstrat dadurch, daß das Haftvermögen der Schicht und des Substrats geringer als das Haftvermögen zwischen der Schicht und dem Trägermaterial ist.

**2.** Verfahren nach Anspruch 1,
**gekennzeichnet durch**
thermisches Bonden des Trägermaterials mit der Halbleiterlegierungsschicht.

**3.** Verfahren nach Anspruch 1,
**dadurch gekennzeichnet,**
daß das Ersatzsubstrat ein Endlosband (14) ist.

**4.** Verfahren nach Anspruch 1,
**gekennzeichnet durch**
kontinuierliches Abscheiden der Halbleiterlegierungsschicht durch Ausbilden und Unterhalten einer Glimmentladung.

**5.** Verfahren nach Anspruch 1,
**dadurch gekennzeichnet,**
daß der Trennschritt aufweist: Unterwerfen der Schicht, des Ersatzsubstrats und des Trägermaterials einem Wärmeschock (302;)
wobei das Ersatzsubstrat einen Wärmeausdehnungskoeffizienten hat, der von demjenigen der Schicht verschieden ist.

6. Verfahren nach Anspruch 1,
 **dadurch gekennzeichnet,**
 daß das Ersatzsubstrat rostfreien Stahl aufweist.

7. Verfahren nach Anspruch 5,
 **dadurch gekennzeichnet,**
 daß Aufheizen zur Erzeugung des Wärmeschocks angewandt wird.

8. Verfahren nach Anspruch 1,
 **gekennzeichnet durch**
 Formen (80) der Halbleiterlegierungsschicht zu photovoltaischen Einzelzellen nach der Trennung der Schicht und des Trägermaterials von dem Ersatzsubstrat.

9. Verfahren nach Anspruch 1,
 **gekennzeichnet durch**
 Abscheiden einer elektrisch leitenden Schicht auf dem Ersatzsubstrat vor dem Abscheiden der genannten Schicht.

FIG. 1

FIG. 2

FIG. 3

EP 0 218 193 B1